# EUROPÄISCHE PATENTSCHRIFT

(11) **EP 3 257 090 B1**
(45) Veröffentlichungstag und Bekanntmachung des Hinweises auf die Patenterteilung: **02.01.2019**
(21) Anmeldenummer: 16708345.0
(22) Anmeldetag: 13.02.2016
(51) Int. Cl.: H01L 41/113, H02N 2/18

(54) **PIEZOELEKTRISCHER GENERATOR, TASTER, FUNKMODUL UND VERFAHREN ZUR HERSTELLUNG EINES PIEZOELEKTRISCHEN GENERATORS**
PIEZOELECTRIC GENERATOR, PUSHBUTTON, RADIO MODULE AND METHOD FOR PRODUCING A PIEZOELECTRIC GENERATOR
GÉNÉRATEUR PIÉZOÉLECTRIQUE, MANIPULATEUR, MODULE RADIOÉLECTRIQUE ET PROCÉDÉ DE FABRICATION D'UN GÉNÉRATEUR PIÉZOÉLECTRIQUE

(30) Priorität: 13.02.2015 LU 92655
(43) Veröffentlichungstag der Anmeldung: 20.12.2017
(73) Patentinhaber: Beckmann, Günter, 85221 Dachau (DE)
(72) Erfinder: BISCHUR, Enrico, 80528 München (DE); SCHWESINGER, Norbert, 85386 Eching (DE); ZÄHRINGER, Sandy, 85221 Dachau (DE)
(74) Vertreter: Klemm, Rolf
(86) Internationale Anmeldenummer: PCT/DE2016/100067
(87) Internationale Veröffentlichungsnummer: WO 2016/127980

(56) Entgegenhaltungen:
- DE-A1-102010 016 499
- US-A1- 2001 035 723
- US-A1- 2005 162 042
- US-A1- 2008 203 850

## Beschreibung

### Technisches Gebiet

Die Erfindung bezieht sich auf einen piezoelektrischen Generator, sowie einen Taster, ein Funkmodul und ein Verfahren zur Herstellung eines piezoelektrischen Generators.

### Stand der Technik

Es ist bekannt piezoelektrische Generatoren als Energiewandlungsmodule herzustellen, um mechanische, kinetische Energie in elektrische Energie zu wandeln. Die DE 10 2010 016 499 A1 beschreibt flächige Piezogeneratormodule und ein Verfahren zu ihrer Herstellung. Gewickelte und anschließend flachgedruckte Piezogeneratoren wandeln mechanische Energie in elektrische Energie um.

US 2001/035723 A1 zeigt einen einseitig mit einer Piezofolie bespannten Verformungskörper.

Eines der effizientesten Werkstoffe für den piezoelektrischen Effekt ist eine Blei - Zirkunat - Titanat - (PZT) - Keramik. Es ist ein überlastgeschützter Piezogenerator mit einem Festkörperwandlerelement zur Einkopplung und zum Umwandeln von Deformationsenergie bekannt. Eine Piezokeramik ist mit einem elastischen Wandlerelement verbunden. Durch eine einwirkende Deformationsenergie wird das Wandlerelement verformt, wodurch eine Verformung der Piezokeramik hervorgerufen wird. Die Verformung der Piezokeramik erfolgt wie eine Biegebalkenstruktur.

Eine Lösung, die eine einwirkende Druckkraft senkrecht zur Oberfläche eines piezoelektrischen Materials in eine Zugkraft wandelt ist bekannt. Zur Umsetzung einer Kraft werden zwei Kappen in der Form eines Cymbals eingesetzt, sodass Zugkräfte auf ein piezoelektrisches Material wirken und Vibrationsenergie gesammelt wird. Die Cymbal-Kappen werden oben und unten auf einen piezoelektrischen Kristall aufgebracht. Durch Zusammendrücken der beiden Cymbal-Kappen von oben und unten wird der piezoelektrische Kristall quer dazu gedehnt.

Es ist ein System bekannt, um aus mechanischer Energie elektrische Energie zu wandeln, wobei zwischen zwei parallelen Platten mehrere angeordnete horizontal zueinander spiegelbildliche angeordnete Cymbals zusammen drückbar sind, wenn eine Person auf einem Boden mit einem darunterliegenden System geht.

Die oben beschriebenen Generatoren sind für den Einsatz von Piezokeramiken konzipiert.

### Darstellung der Erfindung

Es ist Aufgabe der vorliegenden Erfindung eine Vorrichtung und ein Herstellungsverfahren zur Steigerung des Wirkungsgrades zur Wandlung von mechanischer, kinetischer Energie in elektrische Energie bereitzustellen.

Erfindungsgemäß wird die Aufgabe durch den Gegenstand der Patentansprüche 1, 14 und 15 gelöst. Vorteilhafte Weiterbildungen ergeben sich aus den Unteransprüchen.

Ein Gedanke der Erfindung ist, durch konstruktive Modifikationen des piezoelektrischen Generators die Steigerung des Wirkungsgrades zu erhöhen. Eine konstruktive Maßnahme ist, ein elektromechanisches Wandlerelement über einer Projektionsfläche, die ein Verformungskörper des piezoelektrischen Generators aufspannt und mit einer zur Projektionsfläche gegenüberliegende Solldruckfläche ausgebildet ist, zu vergrößern, nämlich mindestens über die Projektionsfläche des Verformungskörper hinaus, den Verformungskörper teilweise oder vollständig zu umgreifen. Somit ist das Wandlerelement einer Dehnung, insbesondere einer größeren Dehnung ausgesetzt, das diese größere Dehnung an ein piezoelektrisches Material weitergibt, sodass eine höhere elektrische Energie mit einem höheren Wirkungsgrad erzeugbar ist.

Der piezoelektrische Generator ist mit einem Verformungskörper ausgebildet, der eine Projektionsfläche aufspannt und mit einer der Projektionsfläche gegenüberliegen Solldruckfläche, wobei die Projektionsfläche aus einer nicht-unter Druck belasteten kleineren Projektionsfläche in eine größere Projektionsfläche bei einer Druckbeaufschlagung auf die Solldruckfläche im Wesentlichen senkrecht zur Projektionsfläche wandelbar ist und eine Federwirkung bereitgestellt ist, die einer Druckbeaufschlagung auf die Solldruckfläche entgegenwirkt, wobei ein elektromechanisches Wandlerelement mit einem piezoelektrischen Material ganz oder teilweise die Projektionsfläche überspannt, sodass das Wandlerelement unter Druckbeaufschlagung auf den Verformungskörper dehnbar ausgebildet ist und elektrische Mikroenergie mittels des piezoelektrischen Materials erzeugbar ist.

Um eine hohe Energieausbeute zu erzielen, ist der Verformungskörper längsförmig und im Profil gesehen satteldachförmig, sowie insbesondere aus einem Hartkunststoff hergestellt, ausgebildet. Eine längsförmige Profilform ist einfach herstellbar und führt zu einer stabilen Herstellbarkeit des piezoelektrischen Generators als Gesamtprodukt. Ein Hartkunststoff wandelt den senkrecht wirkenden Druck wirksam und effizient in einen horizontalen Druck auf das piezoelektrische Material

Damit eine maximale Dehnung des elektromechanischen Wandlerelements umgesetzt wird, ist das elektromechanische Wandlerelement als Hülle um den Verformungskörper gewickelt. Es kann ein flächig größeres Piezomaterial verwendet werden, dass sich um die gesamte Hülle erstreckt.

Gemäß eines wichtigen Gedankens der Erfindung ist das Wandlerelement mit piezoelektrischen Material teilweise oder insbesondere vollständig mit einer flächigen polymeren Piezogeneratorfolie, insbesondere aus Polyvinylidendifluorid (PVDF), ausgebildet. Eine flächige polymere Piezogeneratorfolie hat den Vorteil, dass die Lebensdauer gegenüber einer Keramik deutlich verlängert ist und insbesondere eine Bruchgefahr deutlich vermindert wird. Außerdem wird ein deutlich höherer Wirkungsgrad bei Dehnung der Piezogeneratorfolie erzeugt als bei einer Druckbelastung.

Um einen höheren Wirkungsgrad zu erzielen, das heißt mehr elektrische Energie für ein "Energy Harvesting" zu erzeugen, ist bevorzugt die Piezogeneratorfolie doppellagig, insbesondere mehrlagig ausgebildet.

Gemäß einer der Erfindung weiterbildenden Ausführungsform ist die Piezogeneratorfolie zusätzlich oder alternativ mäanderförmig gewickelt ausgebildet, wobei eine erste Elektrode mit einer ersten Seite und eine zweite Elektrode mit einer zweiten Seite elektrisch leitend verbunden sind. Die Vorteile hierfür sind, dass eine längere Piezogeneratorfolie eingesetzt wird, die wiederum zu einer Leistungssteigerung der erzeugten elektrischen Energie führt.

Gemäß einer der Erfindung weiterbildenden Ausführungsform umfasst der Verformungskörper in einem Winkel angeordnete Schenkel, die zumindest mit einem flexiblen Winkelabschnitt verbunden ausgebildet sind, sodass die Schenkel unter Druckbeaufschlagung zumindest am Winkelabschnitt auseinander schwenkbar sind und insbesondere zumindest der Winkelabschnitt des Verformungskörpers aus einem Werkstoff mit einem Elastizitätsmodul hergestellt ist, mittels dessen eine Federwirkung im Verformungskörper erzeugbar ist. Somit wird mittels eines recht einfach ausgestalteten Verformungskörpers eine auf eine Oberfläche, das heißt auf eine Solldruckfläche wirkenden Druckkraft in eine Zugkraft transformiert, die als Zugkraft auf in eine Polymerfolie eingearbeiteten flächigen Generatoren effizient wirkt. Somit wird die piezoelektrische Folie des piezoelektrischen Generators in Wickelrichtung beispielsweise als Hülle gedehnt. Der Verformungskörper ist dabei im Innenraum des Folienwinkels angeordnet. Die Projektionsfläche, die von dem Schenkel des Verformungskörpers gebildet wird, wird somit bei Druckbeaufschlagung vergrößert, was zu einer Dehnung des darüber gespannten Folienwickels der polymeren Piezogeneratorfolie führt und somit die elektrische Energie erzeugt.

Gemäß einer weiter bevorzugten Ausführungsform ist der Verformungskörper mehrteilig ausgebildet. Das hat den Vorteil, dass jeder Abschnitt als ein Bauteil des Verformungskörpers eine spezifische Funktion zukommt und dementsprechend jedes Bauteil werkstoffoptimiert und konstruktionsoptimiert herstellbar ist.

Gemäß einer der Erfindung weiterbildenden Ausführungsform umfasst der Verformungskörper mindestens ein Winkelscharnier mit zwei Schenkeln daran, wobei das Winkelscharnier eine Feder umfasst. Mittels der Feder lässt sich der Verformungskörper in eine Grundeinstellung mit einem definierten Winkel entgegen einer druckbeaufschlagenden Kraft zurückbewegen.

Gemäß einer weiterbevorzugten Ausführungsform, um eine maximale große Projektionsfläche bei Druckbeaufschlagung zu erzielen, ist das Winkelscharnier mit einer maximalen Tiefe (T) ausgebildet, die eine Stärke (S) von jeweils beiden Schenkeln im Querschnitt gesehen entspricht.

Gemäß einer alternativen bevorzugten Ausführungsform ist das Winkelscharnier mit einer Tiefe (T) ausgebildet, die größer ist, als die Stärke (S) der jeweiligen beiden Schenkeln im Querschnitt gesehen. Dies hat den Vorteil, dass ein Überspannen vermindert wird, das heißt, dass ein Durschlag der Schenkel 180C° in die entgegensetze Richtung, vermieden wird.

Um gemäß einer bevorzugten Ausführungsform eine vorteilhafte Mechanik zu einem Taster in einem Gehäuse herzustellen, ist gemäß einer bevorzugten Ausführungsform die Länge von einem ersten Schenkel länger als vom komplementären zweiten Schenkel ausgebildet.

Gemäß einer alternativen Ausführungsform ist der Verformungskörper im Querschnitt gesehen mit einer Vielzahl von aneinandergereihten Winkeln ziehharmonikaartig ausgebildet, sodass sich die Projektionsfläche bei Druckbeaufschlagung von einem ersten Schenkelpaar bis zu einem gegenüberliegenden Ende eines letzten Schenkelpaars erstreckt. Vorteil dabei ist, dass eine minimale Höhenänderung eine maximale Dehnung und somit maximale Energieausbeute erzeugt.

Gemäß einer alternativen Ausführungsform ist der Verformungskörper im Querschnitt gesehen mit einer bogenförmigen Struktur ausgebildet, wobei die Schenkel vom Wandlerelement mit piezoelektrischen Material überspannt sind, bzw. eine Hülle den Verformungskörper umgeben. Es versteht sich, dass die Federwirkung des Verformungskörpers, wie oben beschrieben, aufgrund eines Elastizitätsmoduls des Werkstoffs vom Verformungskörper realisiert ist oder als separates Federelement alternativ ausgebildet ist.

Gemäß einer alternativen Ausführungsform ist der Verformungskörper zweiteilig mit einer beide Teile verbindenden Gleitstruktur ausgebildet, wobei, im Profil gesehen, zwei gegenüberliegende Enden der beiden Teile jeweils eine Keilform aufweisen, die jeweils ineinandergreifend als schiefe Ebene zueinander lagern, so dass die Teile in einem komprimierten Zustand mit minimaler Projektionsfläche zusammengeschoben, im Querschnitt gesehen mit den Berührungsspitzen überlappend und in einem expandierten Zustand maximal berührend und maximal auseinandergeschoben anordenbar sind.

Gemäß einer alternativen, die Erfindung weiterführenden Ausführungsform ist der Verformungskörper dreiteilig ausgebildet, wobei ein Mittelstück, insbesondere im Querschnitt gesehen ein Zylinder mittig und zwei zum Zylinder beidseitig angeordnete flächige Teile angeordnet sind, wobei die flächigen Teile Ablaufflächen aufweisen, auf denen das dritte Teil gleitbar ist.

Die Erfindung stellt somit einen piezoelektrischen Generator mit einem Verformungskörper bereit, der eine Projektionsfläche bezüglich einer Druckbeaufschlagung aufspannt und mit einer der Projektionsfläche gegenüberliegenden Solldruckfläche ausgebildet ist, wobei die Projektionsfläche aus einer nicht-unter Druck belasteten kleineren Projektionsfläche in eine größere Projektionsfläche bei einer Druckbeaufschlagung auf die Solldruckfläche im Wesentlichen senkrecht zur Projektionsfläche wandelbar ist und der Verformungskörper eine Federwirkung aufweist, die einer Druckbeaufschlagung auf die Solldruckfläche entgegenwirkt, wobei als elektromechanisches Wandlerelement mit piezoelektrischem Material eine Piezogeneratorfolie mit zwei Elektrodenseiten die Projektionsfläche überspannt und mehrfach um den Verformungskörper als Hülle gewickelt ist, so dass die Piezogeneratorfolie unter Druckbeaufschlagung auf den Verformungskörper dehnbar ausgebildet ist. Somit wird ein Piezogenerator geschaffen, der die Lebensdauer in der Anwendung beispielsweise von einem Taster erreicht und zu dem ausreichend elektrischen Energie zur Verfügung stellt.

Der Erfindung wird durch einen Taster mit einem oben beschriebenen piezoelektrischen Generator dadurch gelöst, dass er mit einem Gehäuse, in dem der piezoelektrische Generator untergebracht ist und einem Tastelement mit dem die Solldruckfläche des Verformungskörpers mechanisch mit Druck beaufschlagbar ist, ausgebildet ist. Somit wird in Form eines Kastenmoduls elektrische Energie erzeugt, die zur Signalübertragung notwendig ist. Eine Batterie und deren Austausch nach dem Energieverbrauch sind somit nicht mehr notwendig.

Der Erfindung wird auch durch ein Funkmodul mit einem oben beschriebenen mechanischen Taster gelöst, der einen piezoelektrischen Generator, wie oben beschrieben umfasst und eine Funkeinheit mit einer Steuerelektronik, einer Gleichrichtereinheit und gegebenenfalls eine Energiespeichereinheit aufweist. Die Gleichrichtereinheit sowie eine Funkeinheit und eine Steuerelektronik können im piezoelektrischen Generator implementiert oder auf der piezoelektrischen Folie aufgedruckt sein. Mit dem Funkmodul lassen sich Tastsignale beispielsweise innerhalb eines Raumes übertragen. Ein Funkmodul als Sensor mit einem mechanischen Taster hat den Vorteil, dass ein hoher unvorteilhafter Verkabelungsaufwand wegfällt, wodurch Ressourcen geschont werden. Außerdem kann der Taster als mobiler Sensor im Raum genutzt werden und in vielfältigen Anwendungen eingesetzt werden. Damit das Funkmodul auch ohne einer Erneuerung einer Energiespeichereinheit über mehrere Jahre hindurch zuverlässig arbeitet, ist in das Funkmodul der piezoelektrischen Generator eingebaut.

Die Erfindung wird auch durch ein Verfahren zur Herstellung eines piezoelektrischen Generators gelöst, wobei eine polymere Piezogeneratorfolie als Wandlerelement mit piezoelektrischem Material zu einer Hülle um einen Verformungskörper mit Federwirkung gewickelt wird, wobei der Verformungskörper bezüglich einer Solldruckfläche eine Projektionsfläche aufspannt und mit einer der Projektionsfläche gegenüberliegende Solldruckfläche ausgebildet ist, wobei die Projektionsfläche aus einer nicht-unter Druck belasteten kleineren Projektionsfläche in eine größere Projektionsfläche bei einer Druckbeaufschlagung auf die Solldruckfläche im Wesentlichen senkrecht zur Projektionsfläche wandelbar ist. Somit wird ein effizienter piezoelektrischer Generator geschaffen, der bruchsicher ist und dessen Lebensdauer anwendungsspezifisch sichergestellt ist.

Die Erfindung wird auch durch ein Verfahren zur Erzeugung elektrischer Energie, mittels eines oben beschriebenen piezoelektrischen Generators gelöst, wobei der piezoelektrische Generator mit einem Verformungskörper ausgebildet ist.

### Kurze Beschreibung der Zeichnungen

Weitere Vorteile, Einzelheiten und Weiterbildungen der Erfindung werden in der nachfolgenden Beschreibung unter Bezugnahme auf Zeichnungen erläutert. Es zeigen:
Fig. 1 einen Querschnitt einer gewickelten polymeren Piezogeneratorfolie ohne Verformungskörper;
Fig. 2a, 2b im Querschnitt gesehen den piezoelektrischen Generator mit einem Verformungskörper mit einem Scharnier und zwei gleichlangen Schenkeln im entspannten und im belasteten Zustand;
Fig. 3a, 3b eine alternative zweite Ausführungsform eines piezoelektrischen Generators gemäß Fig. 2 im entspannten und im belasteten Zustand;
Fig. 4a, 4b eine weitere dritte bevorzugte Ausführungsform eines piezoelektrischen Generators im entspannten und im belasteten Zustand;
Fig. 5a, 5b eine vierte bevorzugte Ausführungsform eines piezoelektrischen Generators im entspannten und im belasteten Zustand;
Fig. 6a, 6b eine fünfte bevorzugte Ausführungsform eines piezoelektrischen Generators im entspannten und belasteten Zustand;
Fig. 7a, 7b eine sechste bevorzugte Ausführungsform eines piezoelektrischen Generators im entspannten und belasteten Zustand;
Fig. 8a, 8b eine siebte bevorzugte Ausführungsform eines piezoelektrischen Generators im entspannten und belasteten Zustand;
Fig. 9a, 9b eine bevorzugte achte Ausführungsform eines piezoelektrischen Generators im entspannten und belasteten Zustand.
Fig. 10 einen erfindungsgemäßen Taster und
Fig. 11 ein erfindungsgemäßes Funkmodul.

### Bester Weg zur Ausführung der Erfindung

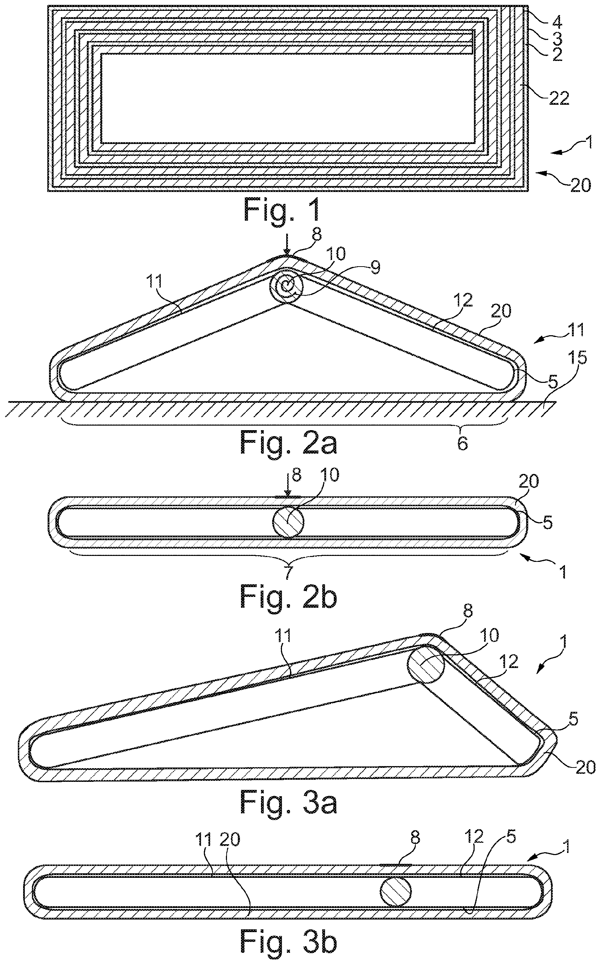

Die Fig. 1 zeigt im Querschnitt gesehen einen erfindungsgemäßen piezoelektrischen Generator 1, ohne einen Verformungskörper 5. Die Fig. 1 zeigt in einem vergrößerten Ausschnitt in abstrahierter Weise einen zu einer Hülle 20 gewickelten Folienkörper oder auch Folienwickel genannt, der bevorzugt eine piezoelektrische polymere Folie 2 aufweist, wie sie in der DE 10 2010 016 499 A1 beschrieben ist. Die piezoelektrische Folie 2 ist im Gegensatz zur Beschreibung der ersten Ausführungsform der DE 10 2010 016 499 A1 nicht mäanderartig gefaltet, sondern gemäß der zweiten Ausführungsform auf zwei piezoelektrischen Folien übereinander doppellagig gewickelt. Beide dort beschriebene Ausführungsformen sind zur Realisierung der vorliegenden Erfindung möglich. Es ist möglich eine mäanderartig gefaltete Folie 2 als Hülle 20, wie in der Fig. 1 gezeigt, zu wickeln oder eine einfach- oder doppel- oder mehrfachlagige piezoelektrische Folie 2, 22 zu wickeln. Die piezoelektrische Folie 2 als Wandlerelement ist bevorzugt aus Polyvinylidendifluorid (PVDF) hergestellt. Jede Seite der piezoelektrischen Folie2, 22 bildet eine folienartige Elektrode 3, 4. Zwischen den einzelnen Elektrodenschichten sind mindestens einer Isolatorschicht angeordnet. Die piezoelektrische Folie 2 ist bevorzugt metallisch beschichtet. Der Herstellungsprozess erfolgt entweder durch eine Gasphasenabschaltung oder durch einen Sputter-Prozess. Die beiden Elektroden 3, 4 sind bevorzugt aus demselben Werkstoff hergestellt und können weiterbevorzugt in einem gemeinsamen Verfahrensschritt hergestellt werden. Die Dicke der piezoelektrischen Folien 2, 22 beträgt zwischen 10 µm und 50 µm. Die piezoelektrische Folie 2 ist sehr kostenintensiv und verlangt deshalb nach einen effizienten Umgang zur Herstellung des piezoelektrischen Generators 1. Die piezoelektrische Folie 2 ist mit einer derartigen Länge gewickelt, sodass diese die für die Anwendung benötigte Energie mit einer ausreichenden Sicherheit in einem Belastungszustand, das heißt bei Dehnung erzeugt. Die maximale Dehnung ist dabei derart ausgelegt, dass diese unterhalb einer Bruch- bzw. Reißgrenze liegt.

Die Fig. 2a zeigt einen piezoelektrischen Generator 1 mit einem erfindungsgemäßen aus Hartkunststoff hergestellten Verformungskörper 5, um den eine zur Fig. 1 beschriebene piezoelektrische Folie 2 als Folienwickel und Hülle 20 gewickelt ist. Zur Vereinfachung sind die erste Elektroden 3 und die zweite Elektrode 4, sowie der genaue Aufbau der Hülle 20 in den Fig. 2, 3, 4, 5, 6, 7, 8 und 9 weggelassen. Die Fig. 2a zeigt den piezoelektrischen Generator 1 in einem unbelasteten Zustand. Der piezoelektrische Generator 1 spannt mit dem Verformungskörper 5 eine Projektionsfläche 6 auf, die bei einer Druckbelastung auf eine gegenüberliegende Solldruckfläche 8 einen Druck gegen eine abstrahierte dargestellte Bodenfläche 15 ausübt. Die Fig. 2b zeigt einen maximal belasteten Zustand, in dem die Projektionsfläche 6 zu einer Projektionsfläche 7 gewandelt und expandiert ist. Der Verformungskörper 5 gemäß Fig. 2a, 2b weist zwei Schenkel 11, 12 auf und ist mittels eines Scharniers 10 verbunden. Im Scharnier ist eine Feder 9 integriert, die den Verformungskörper 5 in einen entspannten Zustand gemäß der Fig. 2a hält und in diesen bei einer Druckbeaufschlagung zurückführt. Der Verformungskörper 5 ist also dreiteilig mit zwei Schenkeln 11, 12 und einem Winkelscharnier 10 aufgebaut.

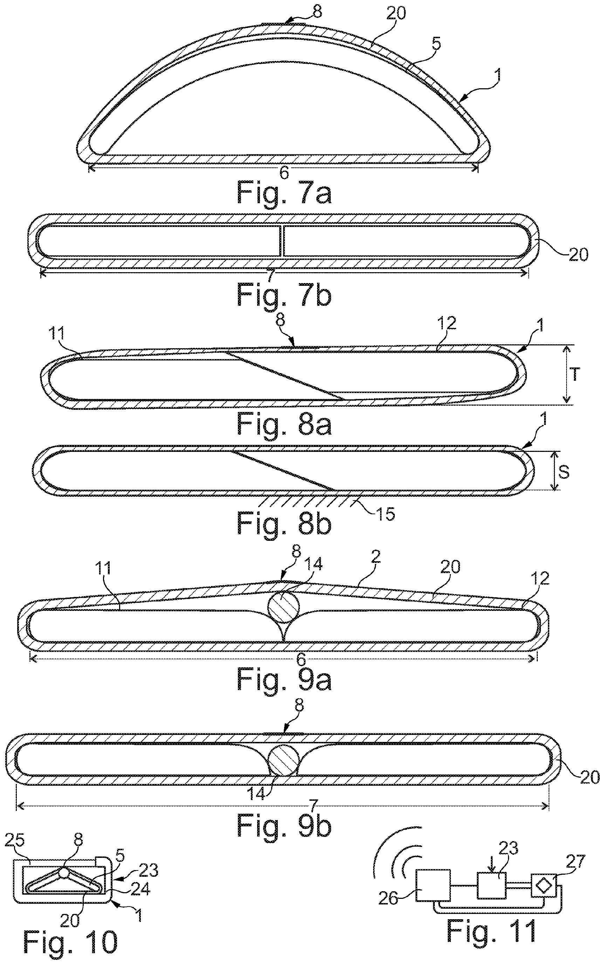

Die Fig. 3a, 3b zeigen im Querschnitt gesehen den piezoelektrischen Generator 1 gemäß Fig. 2a, 2b mit dem Unterschied, dass bei dieser zweiten besonders bevorzugten Ausführungsform der Schenkel 11 des Verformungskörpers 5, deutlich länger als der Schenkel 12 im Querschnitt gesehen ausgebildet ist. Diese Ausführungsform bringt Vorteile in der Mechanik eines Tasters 23, wenn ein darüber liegendes Tastelement 25 beispielsweise am Schenkelende vom Schenkel 11 drehbar gelagert ist, wie dies weiter unten zur Fig. 10 beschrieben und dargestellt ist.

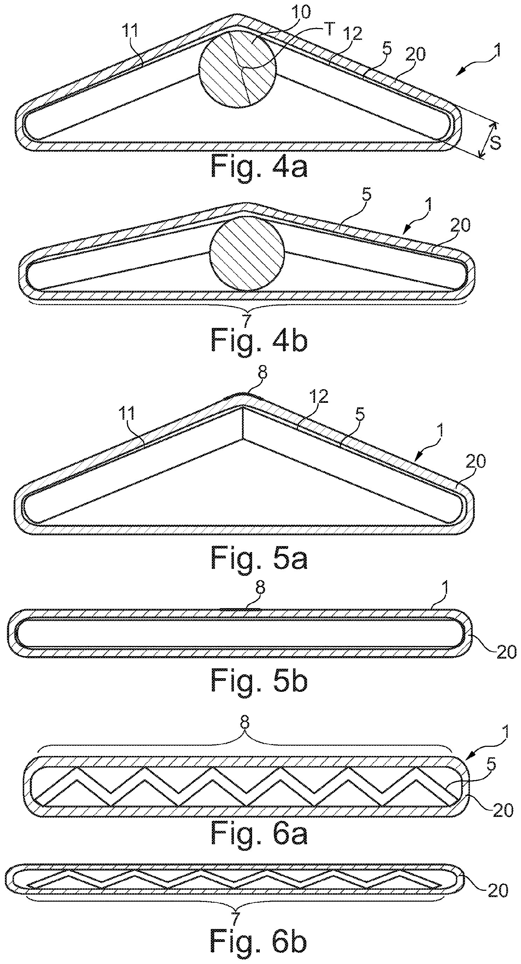

Die Fig. 4a, 4b zeigt eine dritte bevorzugte Ausführungsform, wobei der Verformungskörper 5 wiederum mit gleichlangen Schenkeln 11, 12 ausgebildet ist, jedoch das Scharnier 10 eine maximale Tiefe (T) aufweist, die deutlich über der Stärke (S) der beiden Schenkeln 11, 12 ausgebildet ist. In der Fig. 4a, 4b ist die Tiefe (T) des Scharniers 10 ungefähr doppelt so groß dargestellt wie die Schenkelstärke (S) der Schenkel 11, 12.

Wie in der Fig. 4b gezeigt ist, hat diese Ausführungsform den Vorteil, dass ein Überspannen des Verformungskörpers 5 bei der Wandlung zur Projektionsfläche 7 im maximal belasteten Zustand verhindert wird. Der Verformungskörper 5 lässt sich um eine definierte, kleinere Tiefe als in der Fig. 2 gezeigt dehnen. Dies ist in der Regel ausreichend, da sehr kleine Bewegungen bzw. Dehnungen ausreichen, um die maximale elektrische Energie im piezoelektrischen Generator 1 zu erzeugen.

Die Fig. 5a, 5b zeigen den piezoelektrischen Generator 1 in einer vierten besonderen bevorzugten Ausführungsform. Bei dieser vierten Ausführungsform ist der Verformungskörper 5 ohne ein separates Scharnier 10 ausgebildet. Die Schenkel 11 und 12 sind aus einem einheitlichen elastischen Werkstoff hergestellt. Der Werkstoff weist ein entsprechend ausgelegtes Elastizitätsmodul auf, um eine Federwirkung zwischen einem entspannten Zustand wie in Fig. 5a gezeigt und einem belasteten Zustand bei einer Belastung auf die Solldruckfläche 8 gemäß der Fig. 5b zu erzeugen. Der Verformungskörper 5 ist also einteilig hergestellt.

Die Fig. 6 zeigt im Querschnitt gesehen den erfindungsgemäßen piezoelektrischen Generator 1 in einer fünften bevorzugten Ausführungsform bei der sechs Schenkelpaare im Querschnitt gesehen aneinandergereiht sind und aus einem einheitlichen Werkstoff hergestellt den Verformungskörper 5 ausbilden. Bei dieser Ausführungsform ist die Solldruckfläche 8 fast über die gesamte Querschnittslänge des piezoelektrischen Generators 1 ausgebildet. Ein solcher Aufbau eignet sich beispielsweise in flachen Anwendungen, um mit einem möglichst geringen Hub eine maximale Dehnung zu erzeugen.

Die Fig. 7a, 7b, zeigt eine sechste, besonders bevorzugte Ausführungsform eines piezoelektrischen Generators 1 mit einem bogenförmigen Verformungskörper 5. Um den bogenförmigen Verformungskörper 5 ist die piezoelektrische Folie 2 zur Hülle 20 gewickelt und überspannt sowohl die Schenkelenden als kürzere Sehnen im entspannten Zustand des bogenförmigen Verformungskörpers 5 also auch den Halbbogen. Die Fig. 7b zeigt den Verformungskörper 5 in einem belasteten Zustand mit einer maximalen Projektionsfläche 7 gegenüber der verkleinerten Projektionsfläche 6 aus der Fig. 7a.

Die Fig. 8a, 8b zeigt im Querschnitt gesehen eine siebte besonders bevorzugte Ausführungsform eines piezoelektrischen Generators 1. In dieser Ausführungsform ist der Verformungskörper 5 zweiteilig ausgebildet, wobei sich die zwei Teile mittels einer schiefen Ebene im entspannten Zustand der Mitte überlappen. Die Hülle 20 der piezoelektrischen Folie 2 ist derart gewickelt, sodass die Schenkel 11, 12 übereinander überlappend geschoben sind und eine größere Tiefe (T) erzeugen als deren Schenkelstärke (S). Der Federweg besteht nun in einer Druckbeaufschlagung auf die mittig ausgebildete Solldruckfläche 8 gegen eine Bodenfläche 15, um somit eine Dehnung der Hülle 20 des piezoelektrischen Generators 1 zu erzeugen, sodass die Tiefe (T) sich an der schiefen Ebene auf die Schenkelstärke (S) reduziert und die zwei Schenkel nicht mehr im Querschnitt gesehen überlappend angeordnet sind, sondern gleichmäßig aneinander geschoben sind. Eine Federwirkung kann aufgrund des gedehnten Materials der Hülle 20 oder einer separaten nicht dargestellten Feder erzeugt werden.

Die Fig. 9a, 9b zeigt eine achte, besonders bevorzugte Ausführungsform eines piezoelektrischen Generators 1 mit einem dreiteiligen Verformungskörper 5, dabei sind die Schenkel 11 und 12 separat ausgebildet und haben eine im Querschnitt gesehen kreisförmige abgerundete mittige Oberfläche auf den sich gegenseitig berührenden Kanten, damit ein Zylinder 14 in der Mitte von oben im belasteten Zustand bei Druck auf die mittige darüber liegende Solldruckfläche 8 dazwischen geschoben werden kann, sodass die Hülle 20 der piezoelektrischen Folie 2 den Verformungskörper 5 auf die maximale belastete Projektionsfläche 7 vergrößert gegenüber eines entspannten Zustandes der Projektionsfläche 6, wie in der Fig. 9a gezeigt ist. Im entspannten Zustand liegt somit der Zylinder 14 mittig jeweils auf den Schenkeln 11, 12 in einer abgerundeten Vertiefung und berührt nur oben die Hülle 20 der piezoelektrischen Folie 2. Im belasteten Zustand bei Druck auf die Außenseite der Solldruckfläche 8 kann der Zylinder 14 auch die gegenüberliegende Bodenfläche 24 der Hülle 20 der piezoelektrischen Folie 2 unten berühren.

Die Fig. 10 zeigt in abstrahierter Weise einen erfindungsgemäßen Taster 23 mit einem piezoelektrischen Generator 1, wie dieser oben beschrieben wurde, der in einem Gehäuse 24 verbaut ist und in diesem untergebracht ist, wobei ein Tastelement 25 oberhalb des piezoelektrischen Generators 1 schwenkbar angeordnet ist, sodass mit dem Tastelement 25 auf die Solldruckfläche 8 des piezoelektrischen Generators 1 eine Druckbeaufschlagung des Verformungskörpers 5 realisierbar ist. Dabei wird die gewünschte elektrische Mikroenergie freigesetzt und erzeugt.

Die Fig. 11 zeigt ein Funkmodul mit einem vorherbeschriebenen Taster 23 mit einer Funkeinheit 26 und einer Gleichrichtereinheit 27. Bei einer mechanischen Druckbeaufschlagung auf den mechanischen Taster 23 wird somit Wechselstrom erzeugt, dieser wird über eine Gleichrichtereinheit 27 zu einem Gleichstrom umgewandelt, sodass dieser Gleichstrom eine Funkeinheit 26 mit genügend elektrischer Energie versorgt, um entsprechende Signale an einen Empfänger zu übertragen. Gegenfalls wird die elektrische Energie in einem Kondensator gespeichert. Der Vorteil eines Funkmoduls ist, dass ein Materialeinsatz für eine Verkabelung und der Verkabelungsaufwand wegfallen. Außerdem kann ein Funkmodul in Umgebungen eingesetzt werden, wo eine elektrische Kabelführung schwierig oder unpassend oder unerwünscht ist, wie beispielsweise in stationären oder mobilen Anwendungen.

Obwohl in der vorhergehenden Beschreibung exemplarische Ausführungen erläutert wurden, sei darauf hingewiesen, dass eine Vielzahl von Abwandlungen möglich ist. Außerdem sei darauf hingewiesen, dass es sich bei den exemplarischen Ausführungen lediglich um Beispiele handelt, die den Schutzbereich, die Anwendungen und den Aufbau in keiner Weise einschränken sollen. Vielmehr wird dem Fachmann durch die vorausgehende Beschreibung ein Leitfaden für die Umsetzung von mindestens einer exemplarischen Ausführung gegeben, wobei diverse Änderungen, insbesondere in Hinblick auf die Funktion und Anordnung der beschriebenen Bestandteile, vorgenommen werden können, ohne den Schutzbereich zu verlassen, wie er sich aus den Ansprüchen ergibt.

## Patentansprüche

1. Piezoelektrischer Generator (1) mit einem Verformungskörper (5), der eine Projektionsfläche aufspannt und mit einer der Projektionsfläche gegenüberliegenden Solldruckfläche (8) ausgebildet ist, wobei die Projektionsfläche aus einer nicht-unter Druck belasteten kleineren Projektionsfläche (6) in eine größere Projektionsfläche (7) bei einer Druckbeaufschlagung auf die Solldruckfläche (8) im Wesentlichen senkrecht zur Projektionsfläche (6) wandelbar ist und eine Federwirkung bereitgestellt ist, die einer Druckbeaufschlagung auf die Solldruckfläche (8) entgegenwirkt, wobei ein elektromechanisches Wandlerelement mit einem piezoelektrischen Material ganz oder teilweise die Projektionsfläche (6) überspannt, so dass das Wandlerelement unter Druckbeaufschlagung auf den Verformungskörper (5) dehnbar ausgebildet ist und elektrische Mikroenergie mittels des piezoelektrischen Materials erzeugbar ist, **dadurch gekennzeichnet, dass** das Wandlerelement mit piezoelektrischem Material mit einer flächigen, polymeren Piezogeneratorfolie (2) über die Projektionsfläche (6) des Verformungskörpers (5) hinaus den Verformungskörper (5) umgreifend ausgebildet ist.

2. Piezoelektrischer Generator (1) nach Anspruch 1, **dadurch gekennzeichnet, dass** der Verformungskörper (5) längsförmig und im Profil gesehen satteldachförmig, sowie insbesondere aus einem Hartkunststoff hergestellt, ausgebildet ist, weiter bevorzugt der Verformungskörper (5) mehrteilig ausgebildet ist und insbesondere bevorzugt der Verformungskörper (5) mindestens ein Winkelscharnier (10) mit zwei Schenkeln aufweist, wobei insbesondere das Winkelscharnier (10) eine Feder umfasst, wobei bevorzugt die Länge von einem ersten Schenkel (11, 12) länger als vom komplementären zweiten Schenkel (11, 12) ausgebildet ist.

3. Piezoelektrischer Generator (1) nach Anspruch 1 oder 2, **dadurch gekennzeichnet, dass** das elektromechanische Wandlerelement als Hülle (20) um den Verformungskörper (5) gewickelt ist, weiter bevorzugtdie flächige, polymere Piezogeneratorfolie (2) aus Polyvinylidendifluorid (PVDF) ausgebildet ist, bevorzugt die Piezogeneratorfolie (2) doppellagig, insbesondere mehrlagig, ausgebildet ist.

4. Piezoelektrischer Generator (1) nach Anspruch 3, **dadurch gekennzeichnet, dass** das die Piezogeneratorfolie (22) mäanderförmig gewickelt ausgebildet ist, wobei eine erste Elektrode (3) mit einer ersten Seite und eine zweite Elektrode (4) mit einer zweiten Seite elektrisch leitend verbunden sind.

5. Piezoelektrischer Generator (1) nach einem der Ansprüche 1 bis 4, **dadurch gekennzeichnet, dass** das der Verformungskörper (5) in einem Winkel angeordnete Schenkel (11, 12) umfasst, die mit zumindest einem flexiblen Winkelabschnitt verbunden ausgebildet sind, so dass die Schenkel (11, 12) unter Druckbeaufschlagung zumindest am Winkelabschnitt auseinander drückbar sind und insbesondere und zumindest der Winkelabschnitt des Verformungskörper (5) aus einem Werkstoff mit einem Elastizitätsmodul hergestellt ist, mittels dessen die Federwirkung des Verformungskörpers (5) erzeugbar ist.

6. Piezoelektrischer Generator (1) nach Anspruch 5, **dadurch gekennzeichnet, dass** das Winkelscharnier (10) mit einer maximalen Tiefe (T) ausgebildet ist, die einer Stärke (S) der jeweils beiden Schenkel (11, 12) im Querschnitt gesehen entspricht.

7. Piezoelektrischer Generator (1) nach Anspruch 5, **dadurch gekennzeichnet, dass** das Winkelscharnier (10) mit einer Tiefe (T) ausgebildet ist, die größer ist, als die Stärke (S) der jeweiligen beiden Schenkel (11, 12) im Querschnitt gesehen.

8. Piezoelektrischer Generator (1) nach einem der Ansprüche 1 bis 7, **dadurch gekennzeichnet, dass** der Verformungskörper (5) im Querschnitt gesehen, flächig mit einer Vielzahl von aneinander gereihten Winkeln ziehharmonikaartig ausgebildet ist und die Projektionsfläche (6) von einem Schenkel bis zum gegenüberliegenden letzten Schenkel erstreckt.

9. Piezoelektrischer Generator (1) nach einem der Anspruch 1, **dadurch gekennzeichnet, dass** der Verformungskörper (5) im Querschnitt gesehen mit einer bogenförmigen Struktur ausgebildet ist.

10. Piezoelektrischer Generator (1) nach einem der Ansprüche 1 bis 5, **dadurch gekennzeichnet, dass** der Verformungskörper (5) zweiteilig, mit einer beide Teile verbindenden Gleitstruktur ausgebildet ist, wobei zwei Enden der beiden Teile, im Profil gesehen, jeweils eine Keilform (11A, 12A) aufweisen, die aufeinander jeweils komplementär zueinander als schiefe Ebene lagern, so dass die Teile in einem komprimierten Zustand zusammengeschoben, im Querschnitt gesehen mit den Berührungsspitzen überlappend und in einem expandierten Zustand maximal berührend und maximal auseinandergeschoben ausbildbar sind.

11. Piezoelektrischer Generator (1) nach einem der Ansprüche 1 bis 5, **dadurch gekennzeichnet, dass** der Verformungskörper (5) dreiteilig ausgebildet ist, wobei ein Mittelstück, insbesondere im Querschnitt gesehen ein Zylinder (14) mittig und zwei zum Zylinder beidseitig angeordnete flächige Teile angeordnet sind, wobei die flächigen Teile Ablaufflächen aufweisen, auf denen das dritte Teil ablaufbar ist.

12. Taster (23) mit einem piezoelektrischen Generator (1) nach einem der vorhergehenden Ansprüche 1 bis 11, mit einem Gehäuse (24), in dem der piezoelektrische Generator (1) untergebracht ist und einem Tastelement (25), mit dem die Solldruckfläche (8) des Verformungskörpers (5) mechanisch mit Druck beaufschlagbar ist.

13. Funkmodul mit einem mechanischen Taster (23) nach Anspruch 12, der einen piezoelektrischen Generator (1) nach einem der vorhergehenden Ansprüche umfasst, einer Funkeinheit (26) mit einer Steuerelektronik, einer Gleichrichtereinheit (27) und einer Energiespeichereinheit.

14. Verfahren zur Herstellung eines piezoelektrischen Generators (1), insbesondere nach einem der Ansprüche 1 bis 11, wobei eine polymere Piezogeneratorfolie (2) als Wandlerelement mit piezoelektrischem Material zu einer Hülle (20) um einen Verformungskörper (5) mit Federwirkung gewickelt wird, wobei der Verformungskörper (5) eine Projektionsfläche aufspannt und mit einer der Projektionsfläche (6) gegenüberliegenden Solldruckfläche (8) ausgebildet ist, wobei die Projektionsfläche aus einer nicht-unter Druck belasteten kleineren Projektionsfläche (6) in eine größere Projektionsfläche (7) bei einer Druckbeaufschlagung auf die Solldruckfläche (8) im Wesentlichen senkrecht zur Projektionsfläche wandelbar ist.

15. Verfahren zur Erzeugung elektrischer Energie, mittels eines piezoelektrischen Generators nach einem der Ansprüche 1 bis 11, wobei der piezoelektrische Generator (1) mit einem Verformungskörper (5) ausgebildet ist, der eine Projektionsfläche aufspannt und mit einer der Projektionsfläche gegenüberliegenden Solldruckfläche (8) ausgebildet ist, wobei die Projektionsfläche aus einer nicht-unter Druck belasteten kleineren Projektionsfläche (6) in eine größere Projektionsfläche (7) bei einer Druckbeaufschlagung auf die Solldruckfläche (8) im Wesentlichen senkrecht zur Projektionsfläche (6) wandelbar ist und eine Federwirkung bereitgestellt ist, die einer Druckbeaufschlagung auf die Solldruckfläche (8) entgegenwirkt, wobei ein elektromechanisches Wandlerelement mit einem piezoelektrischen Material ganz oder teilweise die Projektionsfläche überspannt, so dass das Wandlerelement unter Druckbeaufschlagung auf den Verformungskörper (5) dehnbar ausgebildet ist und elektrische Mikroenergie mittels des piezoelektrischen Materials erzeugbar ist, wobei das Wandlerelement mit piezoelektrischem Material ganz oder teilweise mit einer flächigen, polymeren Piezogeneratorfolie (2) ausgebildet ist.

## Claims

1. Piezoelectric generator (1) with a deformation body (5), that holds a projection surface and is formed with a set pressure surface (8) opposite the projection surface, in which the projection surface can be converted from a smaller projection surface (6) not loaded under pressure to a larger projection surface (7) with a pressure load on the set pressure surface (8) essentially perpendicular to the projection surface (6) and a spring effect is provided, which counteracts a pressure load on the set pressure surface (8), in which an electromechanical transformer element with a piezoelectric material spans over whole or part of the projection surface (6), so that the transformer element under pressure load is formed to that it can extend onto the deformation body (5) and electric micro-energy can be generated by means of the piezoelectric material, **characterised in that** the transformer element with piezoelectric material is formed with a laminar, polymeric piezo-generator film (2) beyond the projection surface (6) of the deformation body (5), reaching around the deformation body (5).

2. Piezoelectric generator (1) according to claim 1, **characterised in that** the deformation body (5) is formed longitudinally and when viewed in profile has the shape of a pitched roof, and is particularly made of a rigid plastic, further preferably the deformation body (5) is formed of multiple parts, and particularly preferably the deformation body (5) exhibits at least one angled hinge (10) with two webs, in which in particular the angled hinge (10) comprises a spring, in which preferably the length of a first web (11, 12) is formed longer than the complementary second web (11, 12).

3. Piezoelectric generator (1) according to claim 1 or 2, **characterised in that** the electromechanical transformer element is wound as a sheath (20) around the deformation body (5), further preferably is formed of laminar, polymeric piezo-generator film (2) of polyvinylidene fluoride (PVDF), preferably the piezo-generator film (2) is formed double-layered, particularly multi-layered.

4. Piezoelectric generator (1) according to claim 3, **characterised in that** the piezo-generator film (22) is formed of a winding in a meandering pattern, in which a first electrode (3) with a first side and a second electrode (4) with a second side are joined so that they conduct electricity.

5. Piezoelectric generator (1) according to any one of claims 1 to 4, **characterised in that** the deformation body (5) comprises webs (11, 12) arranged at an angle that are formed of at least one flexible angular section, so that the webs (11, 12) under pressure load are able to be pushed apart at the angle section and particularly and at least the angle section of the deformation body (5) is made of a material with a modulus of elasticity by means of which the spring effect of the deformation body (5) can be generated.

6. Piezoelectric generator (1) according to claim 5, **characterised in that** the angled hinge (10) is formed with a maximum depth (T) corresponding to a thickness (S) of respectively both webs (11, 12) viewed in cross section.

7. Piezoelectric generator (1) according to claim 5, **characterised in that** the angled hinge (10) is formed with a depth (T) that is greater than the thickness (S) of respectively both webs (11, 12) viewed in cross section.

8. Piezoelectric generator (1) according to any one of claims 1 to 7, **characterised in that** the deformation body (5) viewed in cross section is formed laminar with a plurality of angles arranged in rows pointing away from each other like an accordion and the projection surface (6) of one web extends to the opposite last web.

9. Piezoelectric generator (1) according any one of claim 1, **characterised in that** the deformation body (5) viewed in cross section is formed of an arched structure.

10. Piezoelectric generator (1) according to any one of claims 1 to 5, **characterised in that** the deformation body (5) is formed in two parts, with a sliding structure joining both parts, in which two ends of both parts, viewed in profile, respectively embody a wedge shape (11A, 12A), that are layered on top of each other respectively mutually complementary as a slanting plane, so that the parts in a compressed state are pushed together, viewed in cross section with the contact tips overlapping and in an expanded state are touching each other to the maximum and are able to be formed pushed away from each other to the maximum.

11. Piezoelectric generator (1) according to any one of claims 1 to 5, **characterised in that** the deformation body (5) is formed of three parts, in which a centre piece, particularly a cylinder (14) viewed in cross section is arranged in the centre and two laminar parts are arranged on both sides of the cylinder, in which the laminar parts exhibit contact surfaces over which the third part can pass.

12. Switch (23) with a piezoelectric generator (1) according to any one of the preceding claims 1 to 11, with a housing (24), in which the piezoelectric generator (1) is accommodated and a sensing element (25), with which the set pressure surface (8) of the deformation body (5) is mechanically loaded with pressure.

13. Radio module with a mechanical switch (23) according to claim 12, comprising a piezoelectric generator (1) according to any one of the preceding claims, a radio unit (26) with an electronic control system, a rectifier unit (27) and an energy storage unit.

14. Process for manufacturing a piezoelectric generator (1), particularly according to any one of claims 1 to 11, in which a polymeric piezo-generator film (2) as a transformer element with piezoelectric material is wound into a sheath (20) around a deformation body (5) with spring effect, in which the deformation body (5) spans over a projection surface and is formed with a set pressure surface (8) opposite to the projection surface (6), in which the projection surface can be converted from a smaller projection surface (6) not loaded under pressure into a larger projection surface (7) with a pressure load on the set pressure surface (8) essentially perpendicular to the projection surface.

15. Process for generating electricity, by means of a piezoelectric generator according to any one of claims 1 to 11, in which the piezoelectric generator (1) is formed with a deformation body (5) that spans a projection surface and with a set pressure surface (8) opposite the projection surface, in which the projection surface can be converted from a smaller projection surface (6) not loaded under pressure into a larger projection surface (7) with a pressure load on the set pressure surface (8) essentially perpendicular to the projection surface (6) and a spring effect is provided counteracting a pressure load on the set pressure surface (8), in which an electromechanical transformer element with a piezoelectric material spans the projection surface in whole or in part, so that the transformer element is formed so that it can extend under pressure load onto the deformation body (5) and electrical micro-energy can be generated by means of the piezoelectric material, in which the transformer element is formed with piezoelectric material either in whole or in part with a laminar, polymeric piezo-generator film (2).

## Revendications

1. Générateur piézoélectrique (1) comportant un élément déformable (5) qui recouvre une surface de projection et qui est pourvu d'une surface de pression de consigne (8) opposée à la surface de projection. La surface de projection peut se transformer d'une surface de projection plus petite (6) non soumise à la pression, en une surface de projection plus grande (7) lorsqu'une pression est exercée sur la surface de pression de consigne (8) sensiblement perpendiculairement à la surface de projection (6) et une action de ressort est produite qui s'oppose à l'application d'une pression sur la surface de pression de consigne (6). Un élément transducteur électromécanique en un matériau piézoélectrique couvre totalement ou partiellement la surface de projection (6) de sorte que l'élément transducteur soit configuré pour être extensible lorsqu'une pression est appliquée sur l'élément déformable (5) et qu'une micro-énergie électrique puisse être générée par le matériau piézoélectrique, **caractérisé en ce que** l'élément transducteur en matériau piézoélectrique est constitué d'une feuille de matériau polymère générateur piézoélectrique plate (2) s'étendant au-delà de la surface de projection (6) de l'élément déformable (5)

2. Générateur piézoélectrique (1) selon la revendication 1, **caractérisé en ce que** l'élément déformable (5) est de forme longitudinale et, vu de profil, en forme de toit en selle, et en particulier fabriqué en matière plastique dure. L'élément déformable (5) est de préférence réalisé en plusieurs parties, et en particulier, le corps déformable (5) présente de préférence au moins une charnière en angle (10) à deux branches, la charnière en angle (10) présentant en particulier un ressort, la longueur d'une première branche (11, 12) étant de préférence plus grande que celle de la seconde branche complémentaire (11, 12).

3. Générateur piézoélectrique (1) selon la revendication 1 ou 2, **caractérisé en ce que** l'élément transducteur électromécanique forme une gaine (20) enveloppant l'élément déformable (5), la feuille plat de polymère générateur piézoélectrique (2) étant de préférence en difluorure de polyvinylidène (PVDF), plus particulièrement la feuille de générateur piézoélectrique (2) est formée de plusieurs couches, plus particulièrement de deux couches.

4. Générateur piézoélectrique (1) selon la revendication 3, **caractérisé en ce que** la feuille de générateur piézoélectrique (22) est enroulée en méandres, une première électrode (3) étant reliée électriquement à un premier côté et une seconde électrode (4) étant reliée électriquement à un second côté.

5. Générateur piézoélectrique (1) selon l'une des revendications 1 à 4, **caractérisé en ce que** l'élément déformable (5) englobe des branches (11, 12) disposées en angle, qui sont reliées à au moins une section angulaire flexible, de sorte que les branches (11, 12) peuvent, lorsqu'une pression est appliquée, s'écarter sous pression au moins, de la section angulaire, et en particulier au moins la section angulaire de l'élément déformable (5) est constituée d'un matériau ayant un module d'élasticité permettant d'exercer l'action élastique de l'élément déformable (5).

6. Générateur piézoélectrique (1) selon la revendication 5, **caractérisé en ce que** la charnière angulaire (10) a une profondeur maximale (T) correspondant à l'épaisseur (S) des deux branches respectives (11, 12) vues en coupe.

7. Générateur piézoélectrique (1) selon la revendication 5, **caractérisé en ce que** la charnière angulaire (10) a une profondeur (T) supérieure à l'épaisseur (S) des deux branches respectives (11, 12) vues en coupe.

8. Générateur piézoélectrique (1) selon l'une des revendications 1 à 7, **caractérisé en ce que** l'élément déformable (5), vu en coupe, est à plat avec une multitude d'angles alignés les uns contre les autres à la manière d'un accordéon, et la surface de projection (6) s'étend d'une branche à la dernière branche opposée.

9. Générateur piézoélectrique (1) selon la revendication 1, **caractérisé en ce que** le corps déformable (5), vu en coupe transversale, a une structure en forme d'arc.

10. Générateur piézoélectrique (1) selon l'une des revendications 1 à 5, **caractérisé en ce que** l'élément déformable (5) est formé de deux parties avec une structure coulissante reliant les deux parties, les deux extrémités des deux parties, vues de profil, ayant chacune une forme en coin (11A, 12A), chacune étant positionnée de manière complémentaire en plan incliné, de sorte que, à l'état comprimé, les pièces sont pressées l'une contre l'autre, avec les pointes de contact se chevauchant, vues en coupe transversale, et à l'état déployé, elles puissent être en contact maximum et s'écarter au maximum.

11. Générateur piézoélectrique (1) selon l'une des revendications 1 à 5, **caractérisé en ce que** l'élément déformable (5) est composé de trois parties, une pièce centrale, plus particulièrement un cylindre (14) vu en coupe transversale, étant disposée au centre et deux parties plates disposées de part et d'autre du cylindre, les parties plates présentant des surfaces de glissement sur lesquelles la troisième partie peut glisser.

12. Bouton (23) avec un générateur piézoélectrique (1) selon l'une des revendications précédentes 1 à 11, avec un boîtier (24) dans lequel est logé le générateur piézoélectrique (1) et avec un élément de bouton (25) par lequel la surface de pression de consigne (8) de l'élément déformable (5) peut être soumise à une pression mécanique.

13. Module radio comportant un bouton mécanique (23) selon la revendication 12, qui comprend un générateur piézoélectrique (1) selon l'une des revendications précédentes, une unité radio (26) comportant une électronique de commande, un redresseur (27) et une unité de stockage d'énergie.

14. Procédé de fabrication d'un générateur piézoélectrique (1), en particulier selon l'une des revendications 1 à 11, dans lequel une feuille de polymère générateur piézoélectrique (2), comme élément transducteur en matériau piézoélectrique, forme une gaine (20) entourant un élément déformable (5) avec effet ressort, l'élément déformable (5) recouvrant une surface de projection et comprenant une surface de pression de consigne (8) à l'opposé de la surface de projection (6), sachant que la surface de projection peut être convertie d'une surface de projection plus petite (6), non soumise à la pression, en une surface de projection plus grande (7) lorsqu'une pression est appliquée sur la surface de pression de consigne (8) sensiblement perpendiculairement à la surface de projection.

15. Procédé de production d'énergie électrique au moyen d'un générateur piézoélectrique selon l'une des revendications 1 à 11, dans lequel le générateur piézoélectrique (1) est composé d'un élément déformable (5) qui recouvre une surface de projection et comprend une surface de pression de consigne (8) opposée à la surface de projection, la surface de projection étant convertible d'une plus petite surface de projection (6) non soumise à la pression en une plus grande surface de projection (7) lorsqu'une pression est appliquée sur la surface de pression de consigne (8) sensiblement perpendiculairement à la surface de projection (6), et une action de ressort est produite qui s'oppose à l'application d'une pression sur la surface de pression de consigne (8), dans lequel un élément transducteur électromécanique en matériau piézoélectrique recouvre entièrement ou partiellment la surface de projection, de sorte que l'élément transducteur est conçu de manière à pouvoir être étiré lorsqu'une pression est appliquée sur le corps de déformation (5), et une microénergie électrique peut être produite au moyen du matériau piézoélectrique, l'élément transducteur avec un matériau piézoélectrique est conçu entièrement ou partiellement en une feuille plat de matériau polymère générateur piézoélectrique (2).
